# EUROPEAN PATENT APPLICATION

(11) **EP 0 591 086 A2**
(43) Date of publication of application: **06.04.1994**
(21) Application number: 93480132.5
(22) Date of filing: 10.09.1993
(51) Int. Cl.: H01L 21/285, H01L 21/3205, C23C 16/44, C23C 16/42

(54) **Low temperature chemical vapor deposition and method for depositing a tungsten silicide film with improved uniformity and reduced fluorine concentration**

(30) Priority: 30.09.1992 US 954783
(71) Applicant: International Business Machines Corporation, Armonk, N.Y. 10504 (US)
(72) Inventor: Gow, Thomas Richard, Williston, VT 05495 (US); Lebel, Richard John, Sheldon, VT 05483 (US)
(74) Representative: Klein, Daniel Jacques Henri

(57) **Abstract**

A tungsten silicide (WSix) film is formed by chemical vapor deposition using the reduction of tungsten hexafluoride (WF6) with dichlorosilane (SiH2Cl2) referred to as DCS and a reducing agent comprising silane (SiH4), hydrogen, or a mixture thereof. According to the method of the present invention, the WSix film is formed in a CVD reactor operating at a low pressure and at a wafer temperature between about 300 and 550°C. In the preferred embodiment, a thin nucleation layer is deposited before the WSix film. The deposited WSix films exhibit low flourine concentrations with good within-wafer uniformity and process stability. The attached plot illustrates a comparison the growth rates (given as the weight in mg per deposition time in Min) versus the wafer temperature in °C, using DCS (curve 10), DCS + SiH₄ (curve 12) and DCS + H2 (curve 14).

## Description

The present invention relates generally to a method for the manufacture of semiconductor wafers using chemical vapor deposition and, in particular, to a method for the chemical vapor deposition of tungsten silicide by the reduction of tungsten hexafluoride (WF6) using dichlorosilane (SiH2Cl2 or DCS).

Tungsten silicide (WSix) has become an important material for integrated circuits due to its ability to form low-resistivity interconnections. One common use for tungsten silicide is in polycide applications in which a tungsten silicide film is deposited over a doped polysilicon layer. For example, such polycide structures are used to form gates in MOSFET devices, or bit or word lines in memory devices. Further, the use of tungsten silicide offers several other advantages including excellent temperature stability and oxidation performance, as well as resistance to chemical attack by wet etchants such as HF.

At present, the predominant method for the production of tungsten silicide films (or layers) is chemical vapor deposition using gas mixtures of WF6 and silane (SiH4) in cold-wall chemical vapor deposition (CVD) reactors. Chemical vapor deposition of WSix offers several advantages over other deposition techniques such as sputtering and evaporation. These advantages include the ability to control the Si However, chemical vapor deposition of WSix using a gas mixture of WF6 and silane produces WSix films having a high fluorine concentration (e.g. a concentration greater than 10²⁰ atoms/cm3).

A high flourine concentration is disadvantageous because flourine that has been incorporated in a deposited WSix film can diffuse to other portions of an integrated circuit (or semiconductor device) and interfere with its performance. For example, the performance of a gate oxide located below a polycide gate in an integrated circuit can be degraded when flourine in the WSix film of the polycide gate structure diffuses to the underlying gate oxide and reacts with it. This reaction increases the thickness of the gate oxide, making it thicker than originally grown. This increase is undesirable because it makes control of the gate oxide thickness difficult, particularly for the thin gates (e.g. those gates having a thickness less than 15 nm) used in smaller geometry devices.

Another problem with the use of a WF6/SiH4 chemistry is that the conformality of the deposited tungsten silicide films is poor. In addition, WSix films deposited using this chemistry may crack and delaminate, especially films patterned into small linewidths or overlying regions of extreme topography.

An alternative to the WF6/SiH4 chemistry discussed above is also used to form WSix films. In this alternative, WSix films are formed by supplying a gas mixture of WF6 and SiH2Cl2 to a cold-wall CVD reactor. A WF6/SiH2Cl2 chemistry allows the deposition of WSix films that have low flourine concentrations, exhibit good conformality, and show reduced cracking and delamination. However, implementation of this chemistry has been hindered by poor process stability and poor within-wafer film uniformity, especially for wafers having a diameter greater than 125 mm. Because DCS is more difficult to decompose than silane, the deposition temperature must typically be higher than for a silane-based process. This is a disadvantage because higher deposition temperatures usually, though not necessarily, reduce the uniformity of deposited WSix films. Also, WSix film deposition using this chemistry is not stable for wafer temperatures below about 400°C because deposition becomes erratic due to poor nucleation at the surface where the WSix film is to be formed.

Thus, there is a need for an improved process for depositing WSix films that provides films of low flourine concentration with improved within-wafer uniformity and process stability over a relatively wide range of Si Further, there is a need for such a process that deposits a WSix film exhibiting good conformality and reduced cracking and delamination.

This need is satisfied, the limitations of the prior art overcome, and other benefits realized in accordance with the principles of the present invention by a method for the chemical vapor deposition of tungsten silicide which includes the reduction of tungsten hexafluoride (WF6) using dichlorosilane (SiH2Cl2) and a reducing agent comprising silane, hydrogen, or a mixture thereof. According to the method of the present invention, a WSix film is formed in a CVD reactor operating at low pressure and at wafer temperatures between about 300 and 550°C. In the preferred embodiment, a thin nucleation layer is first deposited before depositing the WSix film. Also, the present invention provides a method for adjusting the resistivity of the deposited WSix film by varying the proportions of silane and hydrogen supplied to the CVD reactor.

The deposited WSix films exhibit low flourine concentrations with good within-wafer uniformity and process stability. Further, stable WSix film deposition can be performed at wafer temperatures substantially below 400°C.

The foregoing and other objects, features, and advantages of the invention will be apparent from the following more particular description of preferred embodiments of the invention, as illustrated in the accompanying drawings.
FIG. 1 is a graph illustrating the growth rate of a tungsten silicide film as a function of wafer temperature for three different deposition chemistries;
FIG. 2 is a graph illustrating the uniformity of a deposited tungsten silicide film as a function of wafer temperature for three different deposition chemistries; and
FIG. 3 is a graph illustrating the resistivity of a deposited tungsten silicide film as a function of wafer temperature for three different deposition chemistries.

The present invention provides a method for forming a tungsten silicide layer on a semiconductor wafer using chemical vapor deposition. According to the method of the present invention, a tungsten silicide film is formed by supplying a gas mixture of WF6, DCS, and a reducing agent comprising silane (SiH4), hydrogen, or a mixture thereof to a conventional low-pressure CVD cold-wall reactor operated at a low temperature. A deposited tungsten silicide film has a varying stoichiometry given by the general formula WSix where "x" is a real number dependent upon the specific process conditions used for deposition.

In contrast to the present invention, in the prior art, stable WSix films have only been formed using either a gas mixture of WF6 and silane, or a gas mixture of WF6 and DCS, but not a combination thereof. The present invention uses the above-described reducing agent in addition to WF6 and DCS to deposit a stable WSix film.

The type of CVD reactor used may be any of several conventional CVD reactors. For example, a Genus 6000 batch-wafer (200 mm) CVD system that is resistively-heated or a Varian 5101 single-wafer (125 mm) CVD system that is radiantly-heated (note that this particular model is no longer manufactured) may be used. However, the particular structure of the CVD reactor used is not critical to the practice of the invention, and the invention can be practiced on most cold-wall, low-pressure CVD reactors. For example, CVD reactors heated by means other than radiant or resistively-generated energy can be used. Further, the present invention can be used with CVD systems having a plasma capability.

To deposit a tungsten silicide layer onto a semiconductor wafer according to the preferred embodiment of the present invention, the wafer is placed onto a susceptor, or chuck, within the chamber of the CVD reactor. The susceptor is then heated to a temperature between, for example, about 400 to 600°C. The body of the susceptor itself has a relatively high thermal conductivity, and therefore, its temperature is easily monitored and controlled.

It should be noted that in other embodiments a CVD reactor may be used that has a susceptor-less design wherein the reactor does not use a susceptor and the wafer is radiantly heated. The practice of the present invention does not depend in any way upon the use of a CVD system having a susceptor.

After placing the wafer into the CVD reactor, a gas mixture is provided to the reactor while its chamber is maintained at a low pressure of, for example, about 250 to 400 mtorr. It is expected, however, that the present invention may be practiced at pressures up to about one torr. Typically, the gas mixture is provided after the wafer has been heated. The gas mixture is formed by providing several gas flows to the reaction chamber of the CVD reactor. The gases supplied to the reactor are WF6, DCS, and a reducing agent comprising silane, hydrogen, or a mixture thereof. Also, a diluent is typically added to aid in the movement of these gases. The composition of the mixture and the volumetric flows of the component gases can vary over a wide range. Typical gas flows used in the preferred and other embodiments are provided below and in the examples that follow.

A typical gas flow for DCS is between about 140 to 600 sccm. In the preferred embodiment, this can vary between about 20-30 percent higher or lower. However, in general, the DCS flow rate can vary up or down over a wider range for other embodiments, depending upon the particular process and equipment used. The absolute flow rates of DCS and the other gases is not as important as the ratios of these flows provided to the CVD reactor, as discussed below.

The proportion by volume of the gases provided to the CVD reactor is conveniently discussed using the gas flow of DCS as a common reference point. For example, for a WF6 flow of 3.5 sccm and a DCS flow of 140 sccm, the WF6 proportion is 2.5% of the DCS flow.

In the preferred embodiment, the proportion by volume of the reducing agent flowing into the reactor is small relative to the DCS gas flow. More specifically, if the reducing agent consists substantially of silane only, then the proportion of reducing agent provided to the reactor is preferably about 0.5-10% by volume of the DCS gas flow. However, the silane proportion can generally range up to about 50% for other embodiments.

Where the reducing agent consists substantially of hydrogen only, then the proportion of reducing agent provided to the reactor is preferably about 50-90% by volume of the DCS gas flow. In general, though, this proportion can vary between about 20-100%, or more.

In the preferred embodiment, if a mixture of silane and hydrogen is used as the reducing agent, then the proportion of reducing agent by volume, relative to the DCS gas flow, provided to the CVD reactor is between about 1 to 70% depending upon the particular ratio of silane to hydrogen used in the reducing agent.

Where the reducing agent comprises a mixture of silane and hydrogen, the characteristics of the WSix films formed according to the method of the present invention will be intermediate between the characteristics exhibited for films formed using reducing agents consisting substantially of either silane or hydrogen, as discussed in greater detail below. However, it is to be understood that the present invention is applicable to any reducing agent comprising a mixture of silane and hydrogen and that the characteristics of films formed using such a mixture will vary with the actual proportions of silane and hydrogen used therein.

The proportion of WF6 provided to the reactor is preferably between about 1-10% of the DCS flow rate. However, this proportion can be higher where flourine contamination is not a limiting factor.

In addition to the gas flows provided to the CVD reactor as described above, in the preferred embodiment a small proportion of diluent such as argon is provided to the reactor during the formation of the WSix film. For a diluent of argon, the proportion supplied is between about 10-50% relative to the DCS flow rate. In other embodiments, substantially higher proportions of diluent may be used.

In the preferred embodiment, due to the heating of the susceptor in the CVD reactor, the wafer placed thereon will likewise be heated. However, because of the poor susceptor-wafer contact that occurs in a CVD reactor, the wafer temperature is typically significantly lower than the susceptor temperature. This poor contact occurs because only the peaks of the top surface of the susceptor and the peaks of the bottom surface of the wafer are in solid-to-solid conduct. As a result, most of the interface between the wafer and the susceptor is filled with the gas mixture contained within the CVD reactor itself.

Because the CVD reactor is operated at substantially low pressures that approach a near-vacuum, the density of the gas mixture in the susceptor-wafer interface, and likewise its thermal conductivity, is very low. Therefore, most of the heat transfer that occurs between the susceptor and the wafer occurs through a gas layer of substantially lower conductivity than the body of either the susceptor or wafer. These conditions prevent uniform heat transfer to the wafer from the susceptor and cause a significant temperature gradient across the susceptor-wafer interface. Due to this temperature gradient, the temperature difference between the surface of the wafer and the susceptor will be, typically, about 30-100°C, with the susceptor temperature being higher than the wafer temperature. This wide variation in the temperature difference between the susceptor and wafer is due to the high dependency of the difference upon the particular CVD reactor and process conditions used. Thus, for example, for a susceptor temperature between about 400-600°C and a temperature difference of 100°C, the corresponding temperature of the surface of the wafer will be about 300-500°C.

Other reactor designs are possible. As discussed above, in other embodiments, a CVD reactor having no susceptor and using radiant heating may be used. Also, there are several variations in heating methods among CVD reactor systems. As mentioned earlier, these reactors may be radiantly or resistively-heated. Further, in some systems the wafer is clamped to the susceptor or heated by back-side gases to improve heat transfer to the wafer. These variations in reactor design will affect the particular heat transfer characteristics that are observed during processing. However, these and other variations are not critical to the practice of the present invention and are intended to be within the scope thereof.

The deposition of the tungsten silicide film occurs at the heated surface of the wafer. In the preferred embodiment, a WSix film is deposited at wafer temperatures between about 300 to 550°C. In other embodiments, however, it is expected that WSix films may be deposited at wafer temperatures down to about 250°C. Contrasting the present invention with the prior art, the minimum wafer temperature for the stable deposition of a WSix film using a gas mixture of WF6 and DCS alone (i.e. without the addition of a reducing agent according to the present invention) is typically about 400°C, which is significantly higher than the low wafer temperature that can be achieved with the present invention.

The tungsten silicide film formed on the top surface of a semiconductor wafer according to the present invention may be formed over any of several underlying layers previously formed on the wafer. For example, the underlying layer may be polysilicon, as in polycide gate applications, or other layers such as silicon, silicon oxide, or silicon nitride. The method of the present invention will form tungsten silicide films over a large variety of underlying layers commonly found in integrated circuits.

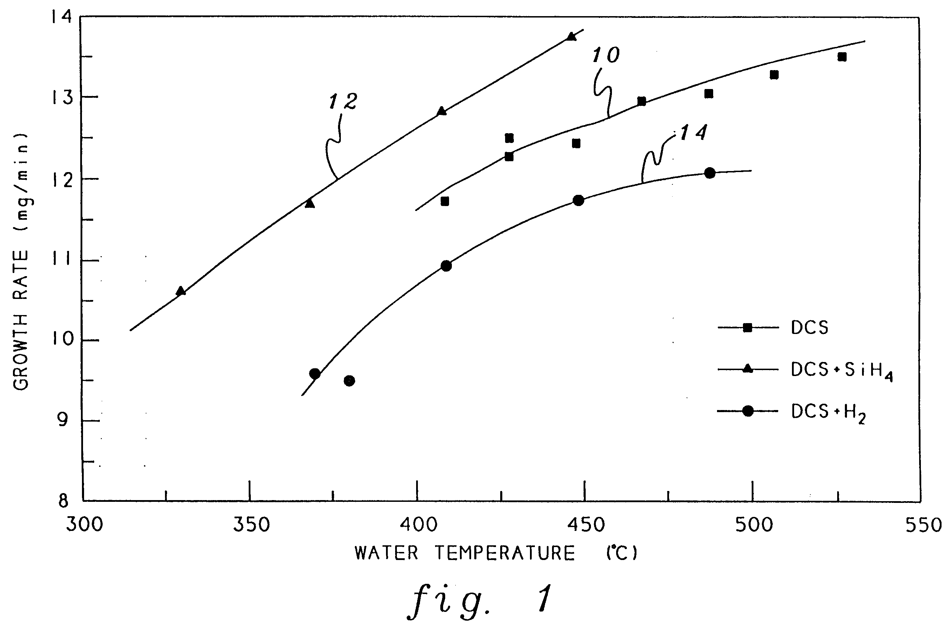

FIGS. 1-3 are graphs that illustrate several properties of WSix films formed in accordance with the method of the present invention. FIGS. 1-3 further compare these properties with those found in WSix films formed using a gas mixture of WF6 and DCS alone.

FIG. 1 is a graph illustrating the growth rate of a tungsten silicide film as a function of wafer temperature for three different deposition chemistries. The growth rate is indicated along the vertical axis of the graph and is given as the weight of a WSix film deposited across the surface of a wafer in milligrams per deposition time in minutes (i.e. mg/min). The wafer temperature during deposition is indicated along the horizontal axis. The growth rate is calculated by weighing the wafer before and after WSix film deposition for fixed time periods of deposition.

Referring to FIG. 1, line (10) shows the growth rate versus wafer temperature for the prior art process using a gas mixture of WF6 and DCS alone and is indicated by the legend "DCS". For temperatures below about 400°C, the prior art process exhibits erratic deposition. In contrast, according to the method of the present invention, line (12) shows the growth rate for a process using WF6, DCS, and a reducing agent consisting substantially of silane. Line (12) is indicated by the legend "DCS+SiH4". Using the method of the present invention, stable WSix film deposition can be done at temperatures substantially below the minimum temperature practical for the prior art process.

Line (14) shows the growth rate for a process using WF6, DCS, and a reducing agent consisting substantially of hydrogen and is indicated by the legend "DCS+H2". Again, using the method of the present invention, WSix deposition can be performed at temperatures substantially below the minimum temperature practical for the prior art process shown by line (10).

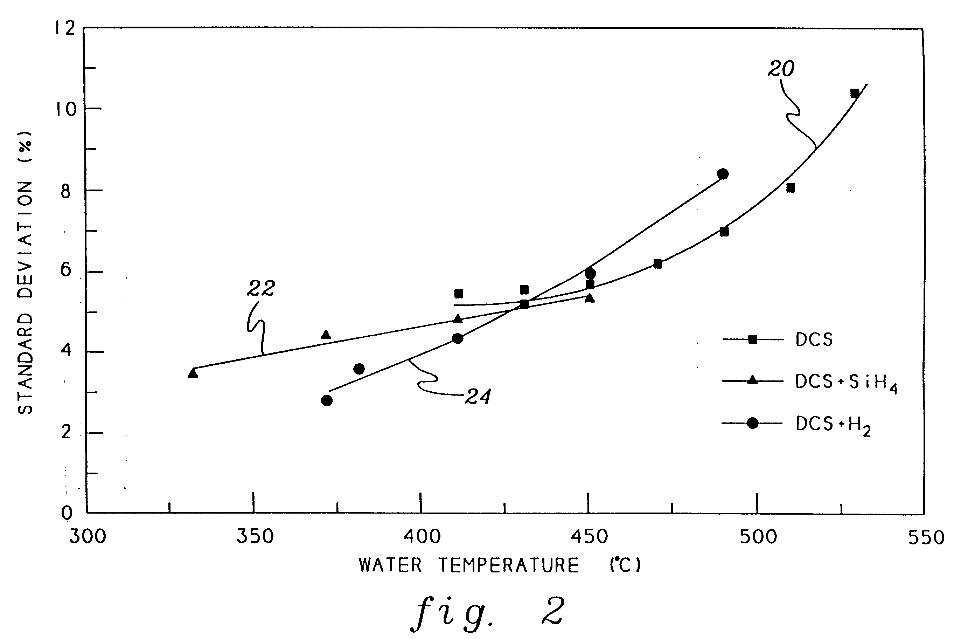

FIG. 2 is a graph illustrating the uniformity of a deposited tungsten silicide film as a function of wafer temperature for three different deposition chemistries. The uniformity of a deposited film is measured using the standard deviation of the sheet resistance (Rs) of an as-deposited WSix film where standard deviation is given in units of percent. The sheet resistance is measured using a conventional four-point probe.

Referring to FIG. 2, line (20) shows the uniformity for the prior art process using WF6 and DCS alone. In contrast, line (22) shows the uniformity achieved according to the method of the present invention for a process using WF6, DCS, and a reducing agent consisting substantially of silane. Note that line (22) reaches a range of standard deviations substantially lower than line (20). Line (24) shows the uniformity achieved by the present invention for a process using a reducing agent consisting substantially of hydrogen. Again, note that line (24) reaches a range of standard deviations substantially lower than line (20).

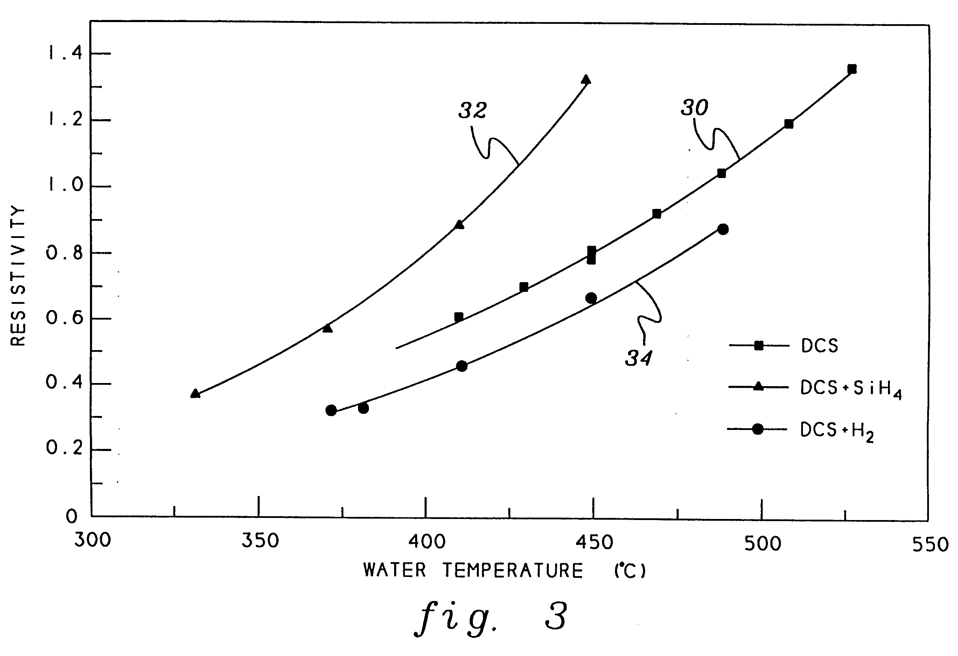

FIG. 3 is a graph illustrating the resistivity of a deposited tungsten silicide film as a function of wafer temperature for three different deposition chemistries. The resistivity indicated on the vertical axis is measured as a normalized bulk resistivity calculated by finding the product of the sheet resistance times the weight of the deposited WSix film. This normalized bulk resistivity is related to the bulk resistivity of the WSix film by a constant that varies with the density of the deposited film. The density of the film changes significantly with temperature because the proportion of silicon in the deposited WSix film increases with temperature. For example, a normalized bulk resistivity of 0.8 in FIG. 3 corresponds to a bulk resistivity of about 750 micro-ohm-cm, depending upon the particular wafer temperature and deposition chemistry.

Referring to FIG. 3, line (30) shows the normalized bulk resistivity for the prior art process using WF6 and DCS alone. Line (32) shows the resistivity for a WSix film formed by the present invention using WF6, DCS, and a reducing agent consisting substantially of silane. Line (34) shows the resistivity for a film formed using a reducing agent consisting substantially of hydrogen. It should be appreciated that, at a given deposition temperature, as the proportion of silane in the gas mixture provided to the CVD reactor increases, the resistivity of the deposited WSix film increases.

Using the method of the present invention as described, WSix films can be formed having a low flourine concentration with improved within-wafer uniformity and process stability over a relatively wide range of Si Further, stable WSix films can be deposited at wafer temperatures substantially below 400°C that exhibit good conformality and reduced cracking and delamination. A significant advantage of the present invention's use of lower deposition temperatures is that the uniformity of the deposited WSix films is increased.

Another significant advantage of the present invention is that a WSix film of a given resistivity, shown by line (32), can be deposited at a lower temperature than possible for the prior art process, shown by line (30). Referring again to FIG. 2, it can be seen that as the wafer temperature for deposition decreases, the uniformity of the deposited film increases. This is shown by lines 22 and 24.

The present invention provides a method for adjusting the resistivity of the tungsten silicide film for a given wafer temperature. The resistivity of the WSix film is adjusted by varying its silicon to tungsten ratio (Si Because the conductivity of silicon is less than that of tungsten, as the proportion of silicon in a WSix film is increased, its resistivity is increased. Thus, as the Si

According to the method of the present invention, the Si More specifically, if an increase in the resistivity of the WSix film is desired, then the proportion of silane in the gas mixture is increased. This change causes the Si

On the other hand, if a decrease in resistivity is desired, then the proportion of hydrogen in the gas mixture is increased. This change causes the Si

It is important to note that simultaneous adjustments in both the proportions of silane and hydrogen in the gas mixture supplied to the CVD reactor can be made, and the adjustment in the resistivity of the deposited WSix film will be a combination of the effects achieved with adjustments to silane or hydrogen alone as described above. The scope of the present invention is intended to cover these combinations.

According to the method of the present invention, a WSix film may be deposited either with or without the use of a thin nucleation layer. In the preferred embodiment, the deposition is performed using a thin nucleation layer of WSix. The purpose of the nucleation layer is to promote more uniform growth of a WSix film deposited thereover. To form a nucleation layer, a two-step process is used in which the nucleation layer is formed in the first step, and the remaining desired thickness for the WSix film is deposited on the nucleation layer in the second step. In the present invention the composition of the nucleation layer will differ from the overlying WSix film primarily in stoichiometry (i.e. the Si It should be noted, however, that in the other embodiments of the present invention, the nucleation layer could have a different composition.

In the first step, the nucleation layer is formed by providing a first gas mixture of WF6, DCS, and a reducing agent comprising silane, hydrogen, or a mixture thereof to the CVD reactor. The first gas mixture is provided to the reactor for a first time period that is, for example, about 30 to 60 seconds. In the second step, a second gas mixture of WF6, DCS, and a reducing agent comprising silane, hydrogen, or a mixture thereof is provided to the reactor. The second gas mixture is provided to the reactor for a second time period of, for example, about 120 to 300 seconds.

In the preferred embodiment, the second time period immediately follows the first time period (i.e. the second time period follows the first time period without substantial delay). However, in other embodiments, there may be a substantial delay between time periods. Further, the first time period can be of substantially greater length if a nucleation layer of greater thickness is desired. The second time period is preferably limited to less than about 500 seconds, but can be longer in general. Both the first and second time periods are generally limited in length only by external factors such as the avoidance of excessive film stress.

A higher proportion of silane in the gas mixture tends to increase flourine contamination in the integrated circuit being formed. However, where this is not a limitation, the proportion of silane relative to DCS in the first gas mixture may be greater than in the second gas mixture so that the Si A WSix film having a higher Si Further, a greater proportion of silane in the gas mixture enhances process stability and the ease of deposition of a WSix nucleation layer. In other embodiments, though, the proportion of silane can remain constant or be lesser in the first gas mixture than in the second.

When using a thin nucleation layer during WSix film deposition, in the preferred embodiment, the proportion of WF6 is increased from the first to second time periods (i.e. the proportion of WF6 in the second gas mixture is greater than in the first gas mixture). Further, it is preferable that the WF6 proportion be between about 0.4-1% of the DCS flow for the first time period. In the second time period the WF6 proportion is preferably between about 1-10%. In other embodiments, however, the WF6 proportion may remain constant or decrease from the first to second time periods.

The method of the present invention is not limited to the changes in gas mixture composition discussed above. In other embodiments, the proportions of other components of the gas mixture can be increased or decreased between the first and second time periods. For example, the proportion of DCS may be increased from the first to second time periods, or the proportion of a diluent such as argon or nitrogen can be changed between time periods.

Further, in alternate embodiments, a WSix film may be deposited without the use of a thin nucleation layer. The use of a nucleation layer is not required for the practice of the present invention. As will be further illustrated in the examples below, a gas mixture of WF6, DCS, and a reducing agent comprising silane, hydrogen, or a mixture thereof having substantially fixed proportions can be provided to the CVD reactor for a single time period to form a WSix film having the advantages provided by the present invention.

The present invention is further illustrated in the examples given below. These examples are provided for the purpose of description, and the details provided therein are not intended to limit the scope of the present invention.

### EXAMPLE 1

A 125 mm diameter silicon wafer, having a layer of polysilicon previously formed thereon over a silicon oxide or silicon nitride layer, was placed in a single-wafer, low-pressure CVD chamber maintained at a pressure of 250 mtorr and clamped on a susceptor whose temperature was varied from 400 to 520°C, which corresponds to a wafer temperature of approximately 330 to 450°C. A mixture of gases consisting of 140 sccm of dichlorosilane, 5 to 15 sccm of silane, 3.5 sccm of tungsten hexafluoride, and 35 sccm of argon was provided to the chamber and contacted the wafer surface for a time period of about 120 seconds. This produced uniform tungsten silicide films ranging from 177 to 267 nm in thickness. The curves labeled "DCS+SiH4" in FIGS. 1-3 represent results for a silane flow of 15 sccm. The table below compares typical results for silane flows of 5 and 15 sccm at wafer temperatures of 370 and 450°C.

| | | | | |
|---|---|---|---|---|
| Wafer Temperature (°C) | 370 | 370 | 450 | 450 |
| SiH4 Flow (sccm) | 5 | 15 | 5 | 15 |
| Deposition Rate (nm/min) | 97 | 110 | 133 | 150 |
| Resistivity (Micro-ohm-cm) | 400 | 570 | 1010 | 1530 |
| Uniformity (percent standard deviation) | 4.12 | 4.48 | 4.84 | 5.32 |

### EXAMPLE 2

A 125 mm diameter silicon wafer, having a layer of polysilicon previously formed thereon over a silicon oxide or silicon nitride layer, was placed in a single-wafer, low-pressure CVD chamber maintained at a pressure of 400 mtorr and clamped on a susceptor whose temperature was varied from 400 to 550°C, which corresponds to a wafer temperature of approximately 330 to 480°C. A mixture of gases consisting of 140 sccm of dichlorosilane, 100 sccm of hydrogen, and 3.5 sccm of tungsten hexafluoride was provided to the chamber and contacted the wafer surface for a time period of about 120 seconds. The curves labeled "DCS+H2" in FIGS. 1-3 represent results for this example.

### EXAMPLE 3

A 200 mm diameter silicon wafer, having a layer of polysilicon previously formed thereon over a silicon oxide or silicon nitride layer, was placed in a multi-wafer, low-pressure CVD chamber maintained at a pressure of 300 mtorr and rested on a susceptor whose temperature was varied from 450 to 560°C, which corresponds to a wafer temperature of approximately 350 to 460°C. A two-step, nucleation-layer process was used. In the first step, a first mixture of gases consisting of 500 sccm of dichlorosilane, 30 sccm of silane, 4 sccm of tungsten hexafluoride and 200 sccm of argon was provided to the chamber and contacted the wafer surface for a first time period of about 30 seconds. This produced a thin nucleation layer of tungsten silicide. Immediately following, in the second step, a second mixture of gases consisting of 500 sccm of dichlorosilane, 10 to 30 sccm of silane, 15 sccm of tungsten hexafluoride and 200 sccm of argon was provided to the chamber and contacted the wafer surface for a second time period of about 300 seconds. This produced uniform tungsten silicide films of 184 to 263 nm total thickness (where total thickness is equal to the WSix nucleation layer thickness plus the overlying WSix film thickness). The table below shows typical results obtained using this process.

| | | | | |
|---|---|---|---|---|
| Wafer Temperature (°C) | 360 | 360 | 430 | 430 |
| SiH4 Flow (sccm) | 10 | 30 | 10 | 30 |
| Deposition Rate (nm/min) | 37 | 39 | 47 | 53 |
| Resistivity (Micro-ohm-cm) | 330 | 390 | 800 | 1010 |
| Uniformity (percent standard deviation) | 3.57 | 3.60 | 4.51 | 4.08 |

### EXAMPLE 4

A 200 mm diameter silicon wafer, having a layer of polysilicon previously formed thereon over a silicon oxide or silicon nitride layer, was placed in a multi-wafer, low-pressure CVD chamber maintained at a pressure of 300 mtorr and rested on a susceptor whose temperature was about 500°C, which corresponds to wafer temperature of approximately 400°C. A two-step deposition process employing a nucleation-layer was used. In the first step, a first mixture of gases consisting of 600 sccm of dichlorosilane, 40 sccm of silane, 4 sccm of tungsten hexafluoride and 200 sccm of argon was provided to the chamber and contacted the wafer surface for a first time period of about 30 seconds. This produced a thin nucleation of layer of tungsten silicide. In the second step, immediately following the first time period, a second mixture of gases consisting of 600 sccm of dichlorosilane, 20 sccm of silane, 15 sccm of tungsten hexafluoride and 200 sccm of argon was provided to the chamber and contacted the wafer surface for a second time period of about 300 seconds. This produced uniform tungsten silicide films of about 2400 Angstroms total thickness.

Although the method of the present invention has been described in detail above, it is not intended to be limited to the specific form set forth herein, but, on the contrary, it is intended to cover such alternatives and equivalents as can reasonably be included within the spirit and scope of the invention as defined by the appended claims. For example, in other embodiments, the present invention can be used for the chemical vapor deposition of metal silicides such as TiSiy or MoSiz using a gas mixture of a metal halide, DCS, and a reducing agent comprising silane, hydrogen, or a mixture thereof.

## Claims

1. A method for forming a metal silicide film on a semiconductor wafer placed in a reaction chamber comprising the steps of:
supplying a gas mixture comprising a metal halide, dichlorosilane, and a reducing agent to said reaction chamber, said reducing agent comprising silane, hydrogen, or a mixture thereof; and
depositing said metal silicide film on said wafer.

2. The method of claim 1 further comprising the step of maintaining the temperature of said wafer below about 550°C.

3. The method of claim 1 further comprising the step of maintaining the pressure of said reaction chamber below about one torr.

4. The method of claim 1 further comprising the steps of: providing a susceptor within said reaction chamber; and
maintaining the temperature of said susceptor below about 650°C.

5. The method of claim 1 further comprising the step of maintaining the temperature of said wafer substantially below about 400°C.

6. The method of claim 1 further comprising the step of maintaining the proportion of silane in said gas mixture below about 50% by volume relative to dichlorosilane.

7. The method of claim 1 further comprising the step of maintaining the proportion of hydrogen in said gas mixture between about 20 to 100% by volume relative to dichlorosilane.

8. A method for fabricating a semiconductor device comprising the steps of:
providing a reaction chamber;
providing a semiconductor wafer having a surface;
placing said wafer in said reaction chamber;
supplying a gas mixture comprising tungsten hexafluoride, dichlorosilane, and silane to said reaction chamber; and
depositing a tungsten silicide film on said surface of said wafer.

9. The method of claim 8 further comprising the step of maintaining the temperature of said wafer between about 300 to 550°C.

10. The method of claim 8 further comprising the step of maintaining the pressure of said reaction chamber between about 250 to 400 mtorr.

11. The method of claim 8 further comprising the steps of: providing a susceptor within said reaction chamber; and
maintaining the temperature of said susceptor between about 400 to 600°C.

12. The method of claim 8 further comprising the step of maintaining the temperature of said wafer substantially below about 400°C.

13. The method of claim 8 wherein the proportion of silane in said gas mixture is between about 0.5 to 10%.

14. The method of claim 8 wherein the step of providing a reaction chamber comprises providing a cold-wall chemical vapor deposition reactor.

15. A method for fabricating a semiconductor device comprising the steps of:
providing a reaction chamber;
providing a semiconductor wafer having a surface;
placing said wafer in said reaction chamber;
supplying a gas mixture comprising tungsten hexaflouride, dichlorosilane, and hydrogen to said reaction chamber; and
depositing a tungsten silicide film on said surface of said wafer.

16. The method of claim 15 further comprising the step of maintaining the temperature of said wafer between about 300 to 550°C.

17. The method of claim 15 further comprising the step of maintaining the pressure of said reaction chamber between about 250 to 400 mtorr.

18. The method of claim 15 further comprising the steps of: providing a susceptor within said reaction chamber; and
maintaining the temperature of said susceptor between about 400 to 600°C.

19. The method of claim 15 further comprising the step of maintaining the temperature of said wafer substantially below about 400°C.

20. The method of claim 15 wherein the proportion of hydrogen in said gas mixture is between about 50 to 90% by volume relative to dichlorosilane.

21. The method of claim 15 wherein the step of providing a reaction chamber comprises providing a cold-wall chemical vapor deposition reactor.

22. A method for forming a tungsten silicide film on a semiconductor wafer in a reaction chamber comprising the steps of:
supplying a gas mixture comprising tungsten hexaflouride, dichlorosilane, and a reducing agent to said reaction chamber, said reducing agent comprising silane, hydrogen, or a mixture thereof; and
depositing said tungsten silicide film on said wafer.

23. The method of claim 22 further comprising the step of increasing the proportion of hydrogen relative to dichlorosilane in said gas mixture to decrease the resistivity of said tungsten silicide film.

24. The method of claim 22 further comprising the step of increasing the proportion of silane relative to dichlorosilane in said gas mixture to increase the resistivity of said tungsten silicide film.

25. A method for forming a tungsten silicide film on a semiconductor wafer in a reaction chamber comprising the steps of:
supplying a first gas mixture comprising tungsten hexaflouride, dichlorosilane, and a reducing agent to said reaction chamber, said reducing agent comprising silane, hydrogen, or a mixture thereof;
depositing a nucleation layer on said wafer for a first time period;
supplying a second gas mixture comprising tungsten hexaflouride, dichlorosilane, and a reducing agent to said reaction chamber, said reducing agent comprising silane, hydrogen, or a mixture thereof; and
depositing said tungsten silicide film overlying said nucleation layer for a second time period.

26. The method of claim 25 wherein the proportion of tungsten hexaflouride relative to dichlorosilane in said second gas mixture is greater than in said first gas mixture.

27. The method of claim 25 wherein the duration of said first time period is less than the duration of said second time period.

28. The method of claim 25 wherein said nucleation layer comprises tungsten silicide.

29. The method of claim 25 wherein said second time period follows said first time period without substantial delay.

30. The method of claim 25 wherein the proportion of silane relative to dichlorosilane in said first gas mixture is greater than in said second gas mixture.

31. The method of claim 30 wherein the proportion of tungsten hexaflouride relative to dichlorosilane in said second gas mixture is greater than in said first gas mixture.

32. The method of claim 25 wherein said second time period is less than about 500 seconds.

33. The method of claim 32 wherein said first time period is between about 30 to 60 seconds.

34. The method of claim 25 further comprising the step of maintaining the temperature of said wafer below about 550°C.
